Europäisches Patentamt

European Patent Office

Office européen des brevets

(19)

(11) **EP 1 605 274 A1**

(12) **EUROPEAN PATENT APPLICATION**

(43) Date of publication:
**14.12.2005 Bulletin 2005/50**

(51) Int Cl.7: **G01R 33/565**

(21) Application number: **04013426.4**

(22) Date of filing: **08.06.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **Bruker BioSpin MRI GmbH**
**76275 Ettlingen (DE)**

(72) Inventors:
• **Hennel, Franciszek Dr.**
**68000 Colmar (FR)**
• **Schneider, Frank Dr.**
**76137 Karlsruhe (DE)**

(74) Representative: **Kohler Schmid Möbus**
**Patentanwälte**
**Ruppmannstrasse 27**
**70565 Stuttgart (DE)**

(54) **Automatic k-space trajectory calibration for MRI**

(57) A method for magnetic resonance imaging (MRI) with an MRI system comprising a homogeneous main magnetic field in which the signal is sampled in the presence of a varying magnetic field gradient generated by a gradient system (GS) comprising at least two, preferably three orthogonal gradient channels, and in which the image is reconstructed with the use of an effective k-space trajectory, is characterised in that at least one of the projections of the effective k-space trajectory on the directions of the gradient channels is calculated by applying a numerical filter to and time integration of an input gradient function ($\widetilde{g}_n$) of the respective gradient channel, whereby the frequency response function of the numerical filter approximates the frequency response function ($R_n(\omega)$) of the respective gradient channel. With the inventive method the reconstruction of an image can be realized without acquiring trajectory data for different gradient pulse shapes.

Fig. 3

**Description**

The present invention relates to a method for magnetic resonance imaging (MRI) with a MRI system comprising a homogeneous main magnetic field in which the signal is sampled in the presence of a varying magnetic field gradient generated by a gradient system comprising at least two, preferably three orthogonal gradient channels, and in which the image is reconstructed with the use of an effective k-space trajectory.

A method for measurement of the effective k-space trajectory is for example known from US 6,239,598 (reference (11))..

In the magnetic resonance imaging (MRI) technique the image is reconstructed by the Fourier transform of data sampled in the so called reciprocal space. The coordinate of each sample of reciprocal space in a given direction is given by the time integral of the gradient of the magnetic field in this direction applied during the evolution of the signal. The sampling trajectory, i.e. the set of coordinates of all samples in the reciprocal space must be known to calculate the Fourier transform. Errors in the trajectory data produce artefacts in the reconstructed image.

In fast MRI methods such as the rectilinear or spiral Echo-Planar Imaging rapidly switched field gradients are used to drive the trajectory though the reciprocal space in a time-efficient manner. Due to the electromagnetic induction the rapid gradient switching produces electric currents in the conductive elements of the MRI device which are placed within the range of the gradient field. These so called eddy currents produce, in turn, concomitant magnetic fields which modify the effective value of the gradient. Due to the eddy currents the effective sample trajectory may differ from the one used for the reconstruction leading to a degradation of the image.

Two main approaches exist to avoid this problem. The first approach, used in all currently commercialized MRI systems, is based on a pre-emphasis of the input gradient pulses which is adjusted or calculated to obtain the effective gradient response as similar as possible to the input pulses. The image is then reconstructed based on the theoretical sample trajectory, which is calculated using the input gradient pulses. This approach is limited for very short gradient switching times because the limited voltage of the gradient power supplies may not allow a sufficient pre-emphasis. Pre-emphasis methods are described in the literature (3-6).

The second approach, which can be used as an alternative or as an addition to the pre-emphasis method, consists of measuring the effective sample trajectory under the influence of the input gradients and of the eddy currents in a special calibration experiment and using this information to reconstruct the data from subsequent imaging experiments.

Several methods for trajectory measurement have been proposed. They are based either on the measurement of signal shifts caused by additional encoding gradient pulses (7,8) or on the signal phase evolution as a function of the signal source position in space. The latter group of methods can be subdivided to those using single-point samples (3-6), Fourier encoding (9,10), or selective excitation (11,12). Thereby it has been ascertained in (9, 10) that the gradient system, including the eddy current effect, can be treated as a linear and time invariant system. The problem of all these methods is the additional scanning time needed for the calibration. The number of additional scans depends on the particular method, but in any case considerably prolongs the overall examination time. The most serious drawback of the trajectory measurement method is the fact that the trajectory data is valid only for a given gradient pulse shape and has to be acquired anew each time the gradient pulse shape is modified. This happens, e.g., when the imaging field of view or the slice orientation is changed. A further problem is that some imaging objects, due to magnetic susceptibility effects, do not allow a precise trajectory calibration, especially at high magnetic fields. In such cases the calibration must be made with a test object using the same imaging parameters as for the actual MRI scan, which limits the practicability of the trajectory-based reconstruction.

The object of the present invention is to propose a method for determining the effective sample trajectory whereby the above mentioned problems, in particular the repeated acquiring of trajectory data for different gradient pulse shapes, can be avoided.

This object is achieved in accordance with the invention in that at least one of the projections of the effective k-space trajectory on the directions of the gradient channels is calculated by applying a numerical filter to and time integration of the input gradient function of the respective gradient channel, whereby the frequency response function of the numerical filter approximates the frequency response function of the respective gradient channel.

The current invention allows the effective trajectory for any readout gradient shape to be obtained without the need for additional measurements. Since the gradient system can be regarded as a linear and time invariant system, it can be treated as a filter with a characteristic frequency response or impulse response function. The filter response can be derived from a single experiment, with a selected test object free of susceptibility problems, in which the trajectory is measured for a reference gradient shape using one of the known methods. Such filter response calculation was shown in (9) and (10) and its application was proposed to predict errors in phase contrast MRI. The essential point of the current invention is the finding that, once the frequency response of the gradient system is known, the effective trajectory can be predicted by applying a numeric filter with this frequency response to the theoretical trajectory. Therefore there is no need anymore to carry out trajectory measurements for different gradient pulse shapes.

In a variant of the inventive method the time integration is performed prior to the application of the numerical filter.

In an alternative variant of the inventive method the time integration is performed after the application of the numerical filter.

In a preferred variant of the inventive method the frequency response function of the gradient channel is determined in a calibration experiment in which the projection of the effective trajectory corresponding to a given reference input gradient function is measured, and the frequency response function of the channel is calculated by dividing the Fourier transform of the projection of the effective trajectory by the Fourier transform of the time integral of the reference input gradient function, when such division is possible, or interpolated otherwise. The frequency response function of the gradient channel comprises information about how an input signal is altered during generation of the effective gradient and can therefore be used for a numerical filter.

Alternatively in another variant of the inventive method the frequency response function of the gradient channel is determined in a calibration experiment in which the projection of the effective trajectory corresponding to a given reference input gradient function is measured, an effective reference gradient as a function of time is calculated for the gradient channel by a derivative in time of the projection of the effective trajectory, and the frequency response function of the channel is calculated by dividing the Fourier transform of the effective reference gradient by the Fourier transform of the reference input gradient function, when such division is possible, or interpolated otherwise. The application of the alternative variants depends on how the required data can be achieved within the MRI system.

In a variant of the inventive method only one or two projections of the k-space trajectory are derived from the gradient response functions and the remaining one(s) in a conventional way.

In a preferred variant an additional correction of the k-space data is made using the frequency response functions of cross-talks between the gradient channels and/or of the cross-talks between the gradient channels and the main magnetic field of the MRI system. Therewith the coupling of the gradient channels and the main magnetic field, which in general cannot be prevented, can be taken into account.

The advantages of the inventive method are emphasized when the imaging data is sampled using Echo-planar Imaging or spiral scan. During Echo-Planar Imaging and spiral scan, which are widespread imaging methods, rapidly switched field gradients are used to drive the trajectory though the reciprocal space in a time-efficient manner. Since the rapidly switched field gradients modify the effective value of the gradient to a great extend, an effective method for correction of artefacts is needed.

In a highly preferred variant the gradient system includes pre-emphasis of the input gradient functions, and the frequency response functions of the numerical filters take into account the effect of the pre-emphasis. In contrast to the trajectory-based image reconstruction, where the data is corrected ex post, the pre-emphasis realises a (limited) correction to the input gradient under maintenance of the desired resolution. Thus a part of the disturbing artefacts is reduced by the pre-emphasis while the resolution can be conserved. The remaining (reduced) artefacts are then removed by the before described numerical filter. In this case the inventive method is used as a final correction. As a result the combination of the pre-emphasis and the inventive numerical filter allows comfortable and time saving reconstruction of the effective sample trajectory within MRI experiments minimizing the loss of resolution.

Further advantages of the invention can be extracted from the description and the drawing. The features mentioned above and below may be used in accordance with the invention either individually or collectively in arbitrary combination. The embodiments shown and described are not to be understood as exhaustive enumeration but have exemplary character for describing the invention.

The invention is shown in the drawings.

Fig. 1        shows a schematic illustration of the problem

Fig. 2a      shows a schematic illustration of the pre-emphasis method according to the state of the art;

Fig. 2b      shows a schematic illustration of image reconstruction using the measured effective trajectory according to the state of the art;

Fig. 3        shows a schematic illustration of the proposed method for image reconstruction using the effective k-space trajectory derived according to the present invention; and

Fig. 4        shows the sequence of operations of the inventive method.

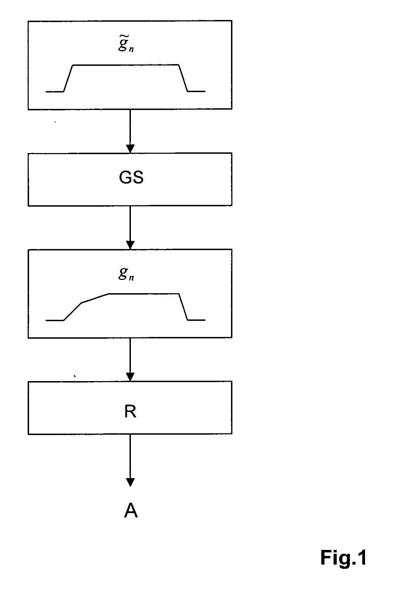

**Fig. 1** illustrates the problem of image degradation. An input gradient $\tilde{g}_n$, is modified by the eddy currents produced by the gradient system GS. Therefore the effective gradient $g_n$ differs from the input gradient $\tilde{g}_n$ which results in a falsified effective sample trajectory and leads to artefacts A in the recorded image I.

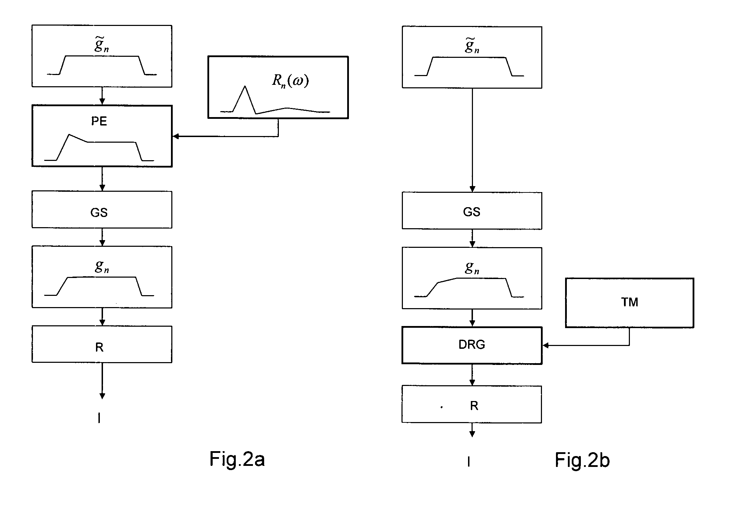

**Fig. 2a** and **Fig. 2b** present two current approaches to avoid the above mentioned problem. In Fig. 2a the input gradient $\tilde{g}_n$ is pre-emphasised. The pre-emphasis depends on the frequency response $R_n(\omega)$ of the gradient system GS and is chosen such that the effective gradient $g_n$ approximates the input gradient $\tilde{g}_n$. Therefore the effective sample trajectory resembles the theoretical sample trajectory. The image I is then reconstructed in the familiar manner. Yet, as mentioned above, this approach is limited for very short gradient switching times because the limited voltage of the gradient power supplies may not allow a sufficient pre-emphasis.

Another approach provides a Trajectory measurement **TM** for measuring the effective sample trajectory under the influence of the input gradient $\tilde{g}_n$ and of the eddy currents in a special calibration experiment. The information of the trajectory measurement TM is used for data re-gridding **DRG** prior to the reconstruction R of the correct image I. Since the trajectory data is valid only for a given gradient pulse shape, the trajectory measurement TM has to be carried out each time the gradient pulse shape is modified. This method of image reconstruction is therefore time consuming and furthermore may lead to a loss of resolution.

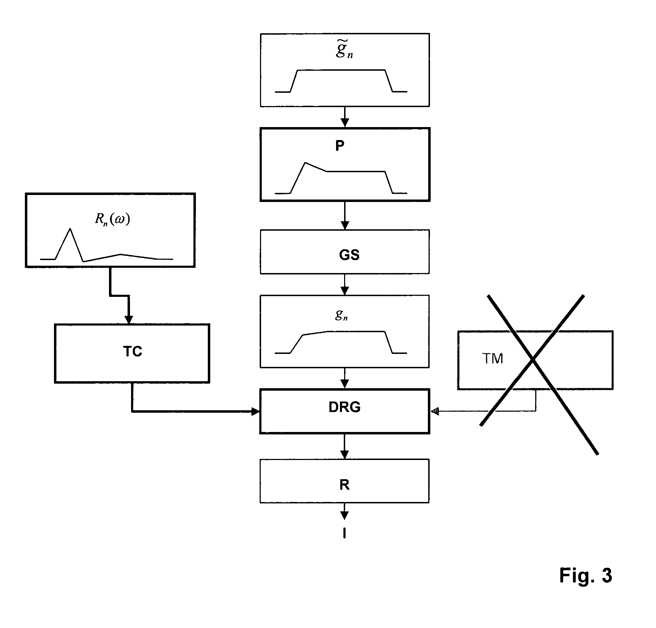

**Fig. 3** illustrates the inventive method for sample trajectory calibration. The idea of the present invention is based on the observation made in (9) and (10) that the gradient system, including the eddy current effect, can be treated as a linear and time invariant system. Thus it can be regarded as a filter with a characteristic frequency response $R_n(\omega)$. The frequency response $R_n(\omega)$ is measured in a single experiment with a test object. Subsequently, the frequency response $R_n(\omega)$) is used to carry out a trajectory calculation TC to figure out the effective trajectory which the gradient system GS produces with a given input gradient shape $\tilde{g}_n$. The effective trajectory is calculated by applying a numerical filter with this impulse response $R_n(\omega)$ to the theoretical trajectory. The effective trajectory is then used for the data re-gridding DRG prior to the image reconstruction R. Since the data re-gridding process DRG can not restore the full resolution of the reconstructed image I, a pre-emphasis PE can optionally be carried out. In this case the frequency response functions of the numerical filters used for the trajectory calculation TC have to take into account the effect of the pre-emphasis. Therefore only small corrections have to be done in the re-gridding process DRG which results in an improvement of the resolution of the reconstructed image I.

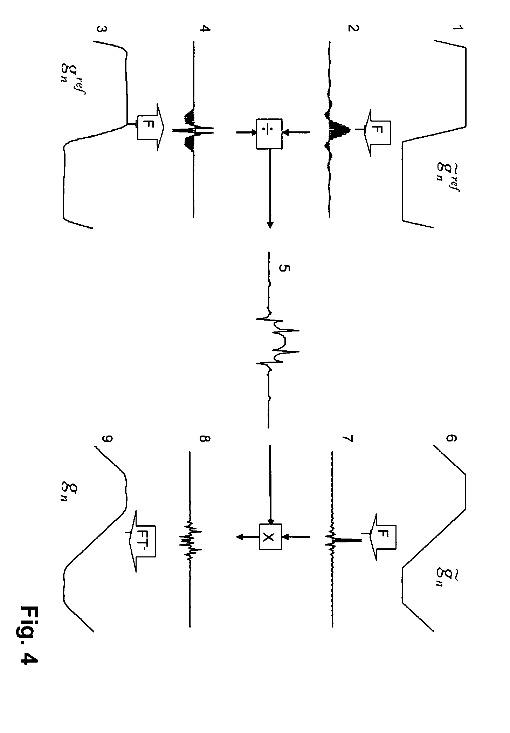

**Fig. 4** shows the sequence of operations of the inventive method. The left column represents the calibration measurement in which the frequency response function $R_n(\omega)$ of the gradient system GS is measured. The frequency response function $R_n(\omega)$ (point 5) is obtained by division of the Fourier transforms (point 2 and 4) of the reference input gradient function $\tilde{g}_n^{ref}$ (point 1) and the effective reference gradient function $g^{ref}_n$ (point 3). This and all other Fourier transform plots shown in this figure contain only the real part. The detailed calculation of the frequency response function $R_n(\omega)$ is given below:

The reciprocal space position of a sample taken at the time point $t$ is given by

$$k_n(t) = \int_0^t g_n(\tau)d\tau, \qquad n = x, y, z \qquad [1]$$

where $g_n$ is the effective gradient (point 9) of the magnetic field in the direction $n$, composed of the input gradient $\tilde{g}_n$, (point 6) and of an additional gradient produced by the eddy currents. Since the eddy currents are an effect of electromagnetic induction, which is a linear and time-invariant phenomenon, the effective gradient $g_n$ can be considered as an effect of filtering of the input gradient $\tilde{g}_n$. It is thus given by the relation:

$$g_n(t) = \tilde{g}_n(t) \otimes r_n(t) \qquad [2]$$

where $\otimes$ denotes the convolution and $r_n(t)$ is the gradient impulse response for channel n, i.e., the effective gradient that would be obtained if the input gradient were an infinitely short impulse of unit integral (Dirac's delta).

The essential element of the invention is the observation that, when the impulse response of all gradient channels is known, the trajectory can be calculated for any input gradient function $\tilde{g}_n$ using equations [1] and [2], or by applying the same filter to the theoretical trajectory $\tilde{k}_n(t)$:

$$k_n(t) = \widetilde{k}_n(t) \otimes r_n(t) \qquad\qquad [4]$$

with

$$\widetilde{k}_n(t) = \int_0^t \widetilde{g}_n(\tau)d\tau. \qquad\qquad [4]$$

Alternatively, the effective trajectory $k_n(t)$ can be derived from the Fourier transform of the impulse response, called the gradient frequency response, $R_n(\omega)$, in the following way:

$$k_n(t) = \mathrm{FT}^{-1}[\widetilde{K}_n(\omega)R_n(\omega)], \qquad\qquad [3]$$

where $\mathrm{FT}^{-1}$ denotes the inverse Fourier transform and $\widetilde{k}_n(\omega)$ is the Fourier transform of $\widetilde{k}_n(t)$.

The impulse response for each gradient channel can be measured using one of the known methods proposed for pre-emphasis calculation (3-6), or the method proposed in (9). Alternatively, is possible to derive the frequency response $R_n(\omega)$ of all gradient channels from a single measurement of the effective trajectory $k_n(t)$ for an applied reference trajectory, $\widetilde{k}_n^{ref}(t)$. The trajectory can be measured, e.g., using the method described in (12). Denoting this measured trajectory $k^{ref}_n(t)$, the frequency response $R_n(\omega)$ is calculated in the following way:

$$R_n(\omega) = \mathrm{FT}[k_n^{ref}(\omega)]/\mathrm{FT}[\widetilde{k}_n^{ref}(\omega)] \qquad\qquad [7]$$

The division in Eq.[7] is shown in Fig. 4, point 5 and can only be calculated for frequencies w for which the denominator has a value significantly different from zero. For the frequencies not fulfilling this condition the frequency response has to be interpolated or set to zero. It is therefore important to use a reference trajectory $\widetilde{k}_n^{ref}(t)$ containing a possibly large spectrum of frequencies.

The right column of Fig. 4 represents the application of the measured frequency response $R_n(\omega)$ to find the shape of the effective gradient $g_n$ (point 9), for a given shape of the input gradient $\widetilde{g}_n$ (point 6). This can be achieved by multiplication of the Fourier transform (point 7) of the input gradient $\widetilde{g}_n$ and the frequency response $R_n(\omega)$, as shown in point 8. An estimate of the effective gradient shape $g_n$ (point 9) in the imaging experiment is then obtained by the inverse Fourier transform of the result of the before mentioned multiplication. The effective trajectory can then be obtained from effective gradient shape $g_n$ (point 9) by integration. Alternatively, the effective trajectory can be obtained directly in point 9 when the input gradient $\widetilde{g}_n$ is replaced with its integral, i.e., with the theoretical trajectory applied in the imaging experiment. The represented shape corresponds to one period of the readout gradient typically used in EPI.

The current invention allows the effective trajectory for any readout gradient shape to be obtained without the need for additional measurements and an improvement of the resolution of the acquired image.

**References**

1. Z.P. Liang and P.C. Lauterbur, Principles of Magnetic Resonance Imaging, IEEE Press, New York, 2000

2. F. Schmitt, M.K. Stehling, R. Turner, editors, Echo-Planar Imaging, Springer Berlin Heidelberg, 1998

3. G.H. Glover and N.J. Pelc, Method for magnetic field gradient eddy current compensation, U.S. Patent Number 4698591 (1987)

4. D.J. Jensen, W.W. Brey, J.L. Delayre, P.A. Narayana, Reduction of pulse gradient setting time in the superconducting magnet of a magnetic resonance instrument, *Med. Phys.* **14**, 859-62 (1987)

5. P. Jehenson, M. Westphal, N. Shuff, "Analytical method for compensation of eddy current effects induced by pulsed magnetic field gradients in NMR systems, J. *Magn. Reson.* **90**, 264-278, (1990)

6. J.J. Van Vaals, A. H. Bergman, Optimisation of eddy-current compensation, *J. Magn. Reson.* **90**, 52-70 (1990)

7. T. Onodera, S. Matsui, K. Sekihara and H. Kohno, A method for measuring field gradient modulation shapes, *J.Phys. E: Sci. Instrum.* **20**, 416-419 (1987)

8. A. Takahashi, T. Peters, Compensation of multidimensional selective excitation pulses using measured k-space trajectories, *Magn. Reson. Med.* **34**, 446-456 (1995)

9. M.T. Alley and N.J. Pelc, Gradient characterization using Fourier-transform, US Patent number 6066949 (1997)

10. M.T. Alley, G.H. Glover and N.J. Pelc, Gradient characterization using Fourier-transform technique, *Magn. Reson. Med.* **39**, 581-587 (1998)

11. Y. Zhang, Process for rapid sample trajectory calibration for magnetic resonance imaging, U.S. Patent number 6239598 (2001)

12. Zhang Y, Hetherington HP, Stokely EM, Mason GF, Twieg DB., A novel k-space trajectory measurement technique, *Magn. Reson. Med.* **39**, 999-1004 (1998)

**reference signs**

| | |
|---|---|
| $R_n(\omega)$ | frequency response functions |
| $\tilde{g}_n$ | input gradient |
| $g_n$ | effective gradient |
| $\tilde{g}_n^{ref}$ | reference input gradient |
| $g^{ref}_n$ | effective reference gradient |
| A | artefact |
| DRG | data re-gridding |
| GS | gradient system |
| I | image |
| PE | pre-emphasis |
| R | reconstruction |
| TC | trajectory calculation |
| TM | trajectory measurement |

**Claims**

1. A method for magnetic resonance imaging (MRI) with an MRI system comprising a homogeneous main magnetic field in which the signal is sampled in the presence of a varying magnetic field gradient generated by a gradient system (GS) comprising at least two, preferably three orthogonal gradient channels, and in which the image is reconstructed with the use of an effective k-space trajectory,
**characterised in
that** at least one of the projections of the effective k-space trajectory on the directions of the gradient channels is calculated by applying a numerical filter to and time integration of the input gradient function ($\tilde{g}_n$) of the respective gradient channel, whereby the frequency response function of the numerical filter approximates the frequency response function ($R_n(\omega)$) of the respective gradient channel.

2. Method according to claim 1, **characterised in that** the time integration is performed prior to the application of the numerical filter.

3. Method according to claim 1, **characterised in that** the time integration is performed after the application of the numerical filter.

4. Method according to any one of the preceding claims, **characterised in that** the frequency response function ($R_n(\omega)$) of the gradient channel is determined in a calibration experiment in which the projection of the effective trajectory corresponding to a given reference input gradient function ($\tilde{g}_n^{ref}$) is measured, and the frequency response function ($R_n(\omega)$) of the channel is calculated by dividing the Fourier transform of the projection of the effective trajectory by the Fourier transform of the time integral of the reference input gradient function ($\tilde{g}_n^{ref}$), when such division is possible, or interpolated otherwise.

5. Method according to any one of the claims 1, 2 and 3, **characterised in that** the frequency response function ($R_n(\omega)$) of the gradient channel is determined in a calibration experiment in which the projection of the effective trajectory corresponding to a given reference input gradient function ($\tilde{g}_n^{ref}$) is measured, an effective reference gradient ($g^{ref}_n$) as a function of time is calculated for the gradient channel by a derivative in time of the projection of the effective trajectory, and the frequency response function ($R_n(\omega)$) of the channel is calculated by dividing the Fourier transform of the effective reference gradient ($g^{ref}_n$) by the Fourier transform of the reference input gradient function ($\tilde{g}_n^{ref}$), when such division is possible, or interpolated otherwise.

6. Method according to any one of the preceding claims, **characterised in that** only one or two projections of the k-space trajectory are derived from the gradient response functions ($R_n(\omega)$) and the remaining ones in a conventional way.

7. Method according to any one of the preceding claims, **characterised in that** an additional correction of the k-space data is made using the frequency response functions ($R_n(\omega)$) of cross-talks between the gradient channels and/or of the cross-talks between the gradient channels and the main magnetic field of the MRI system.

8. Method according to any one of claims 1 through 7, **characterised in that** the imaging data is sampled using Echo-planar Imaging.

9. Method according to any one of claims 1 through 7, **characterised in that** the sampling trajectory in k-space is spiral.

10. Method according to any one of the preceding claims, **characterised in that** the gradient system (GS) includes pre-emphasis (PE) of the input gradient functions ($\tilde{g}_n$), and the frequency response functions ($R_n(\omega)$) of the numerical filters take into account the effect of the pre-emphasis (PE).

**Fig.1**

Fig.2a

Fig.2b

Fig. 3

**Fig. 4**

## EUROPEAN SEARCH REPORT

European Patent
Office

Application Number

EP 04 01 3426

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 377 043 B1 (SCHOMBERG HERMANN ET AL) 23 April 2002 (2002-04-23) * column 1, line 50 - column 2, line 38 * * column 3, line 61 - column 7, line 7 * ----- | 1-10 | G01R33/565 |
| X | US 5 905 377 A (KERR ADAM B ET AL) 18 May 1999 (1999-05-18) * column 3, line 34 - column 4, line 8 * ----- | 1-6,8,9 | |
| D,X | ALLEY M T ET AL: "Gradient characterization using a Fourier-transform technique" MAGNETIC RESONANCE IN MEDICINE, ACADEMIC PRESS, DULUTH, MN, US, vol. 39, no. 4, April 1998 (1998-04), pages 581-587, XP002247772 ISSN: 0740-3194 see pages 582-584 and 587 ----- | 1-10 | |
| A | MASON G F ET AL: "A method to measure arbitrary k-space trajectories for rapid MR imaging" MAGNETIC RESONANCE IN MEDICINE, ACADEMIC PRESS, DULUTH, MN, US, vol. 38, no. 3, September 1997 (1997-09), pages 492-496, XP002247770 ISSN: 0740-3194 see page 496 ----- | 10 | TECHNICAL FIELDS SEARCHED (Int.Cl.7) G01R |

The present search report has been drawn up for all claims

| Place of search | Date of completion of the search | Examiner |
|---|---|---|
| Munich | 22 September 2004 | Lersch, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT**
**ON EUROPEAN PATENT APPLICATION NO.**                    EP 04 01 3426

This annex lists the patent family members relating to the patent documents cited in the above-mentioned European search report.
The members are as contained in the European Patent Office EDP file on
The European Patent Office is in no way liable for these particulars which are merely given for the purpose of information.

22-09-2004

| Patent document cited in search report | | Publication date | Patent family member(s) | | Publication date |
|---|---|---|---|---|---|
| US 6377043 | B1 | 23-04-2002 | DE<br>EP<br>WO<br>JP | 19753093 A1<br>0981762 A1<br>9928758 A1<br>2001510386 T | 02-06-1999<br>01-03-2000<br>10-06-1999<br>31-07-2001 |
| US 5905377 | A | 18-05-1999 | NONE | | |

For more details about this annex : see Official Journal of the European Patent Office, No. 12/82